# EUROPEAN PATENT APPLICATION

(11) **EP 2 159 912 A1**
(43) Date of publication of application: **03.03.2010**
(21) Application number: 08015356.2
(22) Date of filing: 29.08.2008
(51) Int. Cl.: H03F 1/02, H03F 1/07, H03F 3/72, H03F 3/60

(54) **Multi-band Doherty amplifier**

(71) Applicant: Alcatel Lucent, 75008 Paris (FR)
(72) Inventor: Wiegner, Dirk, 71409 Schwaikheim (DE); Jüschke, Patrick, 75428 Illingen (DE)
(74) Representative: Kohler Schmid Möbus

(57) **Abstract**

The invention relates to a Multi-band Doherty amplifier (1) for amplifying an input signal (7) in at least two frequency bands with different center frequencies (f1, f2), comprising: a main amplification path (2) with a main amplifier (3), and at least two auxiliary amplification paths (4a, 4b) with respective peak amplifiers (5a, 5b), wherein the main amplifier (3) is wideband matched and a first / second peak amplifier (5a, 5b) of a first / second auxiliary amplification path (4a, 5b) is matched to the first / second center frequency (f1, f2). The invention also relates to a power amplifier module (21) comprising such a Doherty amplifier (1) and to a base station (22) comprising such a power amplifier module (21).

## Description

### Background of the Invention

The invention relates to a multi-band Doherty amplifier for amplifying an input signal in at least two frequency bands with different center frequencies. The invention also relates to a power amplifier module comprising such a Doherty amplifier and to a base station comprising such a power amplifier module.

Different technologies like WiMAX, UMTS, GSM with different specifications working in different frequency ranges need their own techniques and hardware. To decrease costs and efforts it will be helpful to get several of these technologies combined (e.g. mandatory for SDR (Software Defined Radio) or Cognitive Radio applications). Therefore, it is necessary to cover high frequency bandwidth and to have power amplifiers covering wave bands over a wide frequency range. Additionally, efficiency is a main problem of power amplifiers for modern base stations which clearly influences e.g. material costs, cooling effort, mechanical transmitter size and operating costs. Thus, energy efficiency becomes an important parameter and selling factor. However, due to increased linearity requirements, associated with new complex modulation schemes which are necessary in order to meet the increased demand for high data rates, the realization of highly efficient linear amplifiers becomes more and more complicated. The above-described situation is especially true for multi-band / multi-standard capable base stations (SDR, Cognitive Radio), since they have to cover highly efficient different requirements for different wave bands and different communication standards using the same hardware.

Although it is possible to use conventional class AB based amplifiers as multi-band amplifiers, these would only achieve moderate efficiency for modern communication standards. As beside bandwidth, another important goal is to increase efficiency, output power, linearity etc. over the whole bandwidth, the main problem is to transfer the performance known from narrow-band (single-band) amplifiers to amplifiers with a higher bandwidth. This is especially true e.g. for Doherty the configuration, which is a very promising concept for efficiency-improved single-band amplifiers.

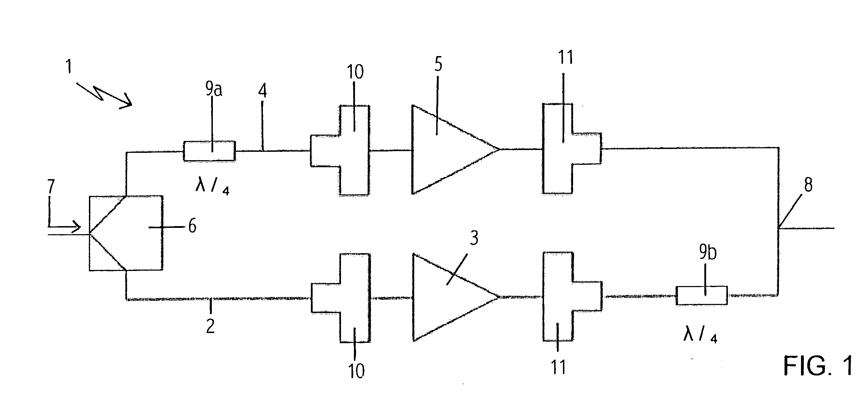

The classical configuration of a conventional Doherty power amplifier **1** is shown in **Fig. 1****.** The Doherty amplifier 1 comprises a main amplification path **2** with a main amplifier **3** biased to work in class AB mode, and an auxiliary amplification path **4** with a peak amplifier **5** biased to operate in class C mode.

A power divider (passive splitter **6**) splits an input signal **7** with equal power to the main amplification path 2 and to the auxiliary amplification path 4. After amplification, the auxiliary amplification path 4 and the main amplification path 2 are re-combined in a power combiner (not shown) at a combining point **8.** For optimized load balancing, a first quarter wave section **9a** is arranged in the main amplification path 2 between the output end of the main amplifier 3 and the combining point 8 and a second quarter wave section **9b** is arranged in the auxiliary amplification path 4 between the splitter 6 and an input end of the auxiliary amplifier 5. The quarter-wave sections 9a, 9b are matched to a common center frequency of the main amplifier 3 and the peak amplifier 5 which are adapted to operate at that center frequency by respective input and output matching networks **10, 11.** During high signal peaks of the input signal 7, the main amplifier 3 saturates and the peak amplifier 5 kicks in. Thus, the Doherty amplifier 1 provides a high power-added efficiency with input signals 7 that have high peak-to-average ratios. However, due to the bandwidth-limiting quarter-wave sections 9a, 9b and load modulation, which are fundamental parts of the Doherty concept, conventional Doherty amplifiers are bandwidth-limited, i.e. are only adapted to amplify a narrow frequency band about the center frequency.

### Object of the Invention

It is the object of the invention to provide a Doherty amplifier, a power amplifier module comprising such a Doherty amplifier, and a base station comprising such a power amplifier module, all of which are adapted to amplify an input signal in two or more frequency bands being typically located in a wide frequency range.

### Summary of the Invention

According to a first aspect, this object is met by a multi-band Doherty amplifier for amplifying an input signal in at least two frequency bands with different center frequencies, comprising: a main amplification path with a main amplifier, and at least two auxiliary amplification paths with respective peak amplifiers, wherein the main amplifier is wideband matched and a first / second peak amplifier of a first / second auxiliary amplification path is matched to the first / second center frequency.

The inventors have found that the Doherty concept may be enhanced to multi-band applications using a wideband matched main amplifier (power transistor) and two or more peak amplifiers, each of them matched to a specific (different) center frequency which is covered by the amplification range of the main amplifier. In such a way, two or more frequency bands may be covered by two or more single-band peak amplifiers which share a common wideband main amplifier, resulting in a highly efficient multi-band Doherty amplifier.

In order to improve the characteristic of the enhanced Doherty amplifier, special design solutions are required for the splitting network on the input side of the Doherty configuration as well as on the output side, the latter one especially in order to guarantee proper load modulation for the two or more covered frequency bands.

In a preferred embodiment, the first / second amplification path comprises a first / second signal blocking unit for blocking the first / second auxiliary amplification path for the second / first center frequency. At a given time, the input signal typically comprises only a single frequency band about the center frequency of the first or the second peak amplifier. As the input signal is typically split with equal power to the main amplification path and to each of the auxiliary amplification paths, peak amplifiers which are not matched to the frequency band of the input signal should be deactivated, such that no power of the input signal will get lost in the currently unused signal path. Additionally, the currently unused auxilliary amplifier / transistor will be turned-off in order not to waste energy. The path deactivation may be performed by blocking the auxiliary signal path to those peak amplifiers using signal blocking units which block the corresponding auxiliary signal paths at least for the center frequency of the frequency band which is amplified by the peak amplifier which is matched to the current center frequency / frequency band of the input signal.

In a further preferred embodiment, the first / second signal blocking unit comprises at least one quarter-wave line section matched to the second / first center frequency. Using quarter-wave line sections, an impedance transformation can be performed in the blocking units which allows to use switch configurations which do not require switching elements to be used as series elements, such that the RF-power which passes through these switching elements is reduced.

Preferably, the first / second signal blocking unit further comprises at least one switching element which is connected to the quarter-wave line section at one end, the other end of the switching element being typically connected to ground, such that the switching element is used as a shunt, thus only part of the RF power passing through the switching element.

In a preferred improvement, the switching element is a PIN diode or a MEM-switch. In the configuration described above, PIN diodes or MEM(Micro-ElectroMechanical) switches which are power-limited to e.g. about 10 Watts may be used as switching elements. It will be understood that other types of switching elements, e.g. RF relays which are typically provided with a suitable configuration for bias adjustment may be used as well for this purpose.

In an advantageous embodiment, the first / second signal blocking unit comprises an input blocking section for blocking the first / second auxiliary path to an input end of the first / second peak amplifier, and an output blocking section for blocking the first / second auxiliary amplification path from a first / second combining point of the first / second auxiliary amplification path with the main amplification path to an output end of the first /second peak amplifier. The above-described configuration of a blocking unit only works as an unidirectional switch due to the impedance transformation using the quarter-wave transmission lines, such that typically, separate blocking sections are provided for the input and the output sections of the auxiliary amplification paths. On the input side, the main advantage is that a (passive) 3dB splitter can be used. On the output side, the advantage is that an open signal path to the unused amplifier is generated so that the signal power does not get lost through the currently unused peak amplifier(s).

In another preferred embodiment, the Doherty amplifier further comprises a splitter for distributing the input signal to the main amplification path and to at least two auxiliary amplification paths. The splitter may be implemented as a conventional passive splitter, or as a frequency-selective splitter which may comprise the input blocking sections to the respective auxiliary amplification paths.

Preferably, the auxiliary amplification paths are combined with the main signal path at combining points arranged at different locations along the main signal path. The different wavelengths / center frequencies used in the different auxiliary amplification paths require different signal path lengths, such that the auxiliary signal paths are typically not combined with the main line at the same combining point.

In a highly preferred embodiment, the auxiliary amplification path from the output end of at least one peak amplifier to the combining point and the main amplification path from the output end of the main amplifier to the combining point are matched to the same characteristic impedance, preferably to 100 Ω. When using the same characteristic impedance for the output sections of different auxiliary amplification paths and of the main amplification path, the load modulation may be designed and matched via different impedance levels to get a combined low-loss output, preferably to 50 Ohm of the Doherty amplifier. For example, when each amplification path is matched to a characteristic impedance of 100 Ohm, only half of the characteristic impedance, i.e. 50 Ohm, is present at the output of the respective combining point. The person skilled in the art will appreciate that impedance matching to other impedance values is also possible.

In a preferred improvement, the first / second auxiliary path from the output end of the first / second peak amplifier to the respective combining point comprises two line sections with different characteristic impedance, one of the line sections being a quarter-wave line section which is matched to the first / second center frequency. In such a way, the characteristic impedance of the respective auxiliary paths at the combining points may be set to a desired value. For example, using a first line section with a characteristic impedance of 50 Ohm and a second line section with a characteristic impedance of 70.7 Ohm, the second line section being a quarter-wave line section, a characteristic impedance of 50 Ohm at the combining point may be obtained.

In another preferred embodiment, the Doherty amplifier further comprises input matching networks and output matching networks for the main amplifier and the peak amplifiers. The input / output matching networks are used to adapt the main amplifier and the peak amplifiers to amplify the frequency bands about their respective center frequencies, the main amplifier being wideband matched, i.e. being adapted to amplify a wide frequency range about a center frequency which includes the center frequencies of the peak amplifiers.

In a highly preferred embodiment the main amplifier and the peak amplifiers have the same power class. In such a case, the Doherty configuration is symmetrical, as the transistors of the respective amplifiers have the same output power capability.

In another advantageous embodiment the power class of the main amplifier is different from the power class of the peak amplifiers. In such a case, the Doherty amplifier is dimensioned asymmetrically. That means that the main amplifier and the peak amplifiers have transistors with different output power capability.

A further aspect of the invention relates to a power amplifier module comprising a Doherty amplifier as described above. The power amplifier module comprises additional circuitry which allows the integration of the power amplification module in a base station for mobile radio applications, the latter constituting another aspect of the invention.

Further features and advantages are stated in the following description of exemplary embodiments, with reference to the figures of the drawing, which shows significant details, and are defined by the claims. The individual features can be implemented individually by themselves, or several of them can be implemented in any desired combination.

### Brief Description of the Drawings

Exemplary embodiments are shown in the diagrammatic drawing and are explained in the description below. The following are shown:
- **Fig. 1**: shows a schematic diagram of a conventional Doherty amplifier, and
- **Fig. 2**: shows an embodiment of a multi-band Doherty amplifier according to the invention.

### Detailed Description of Preferred Embodiments

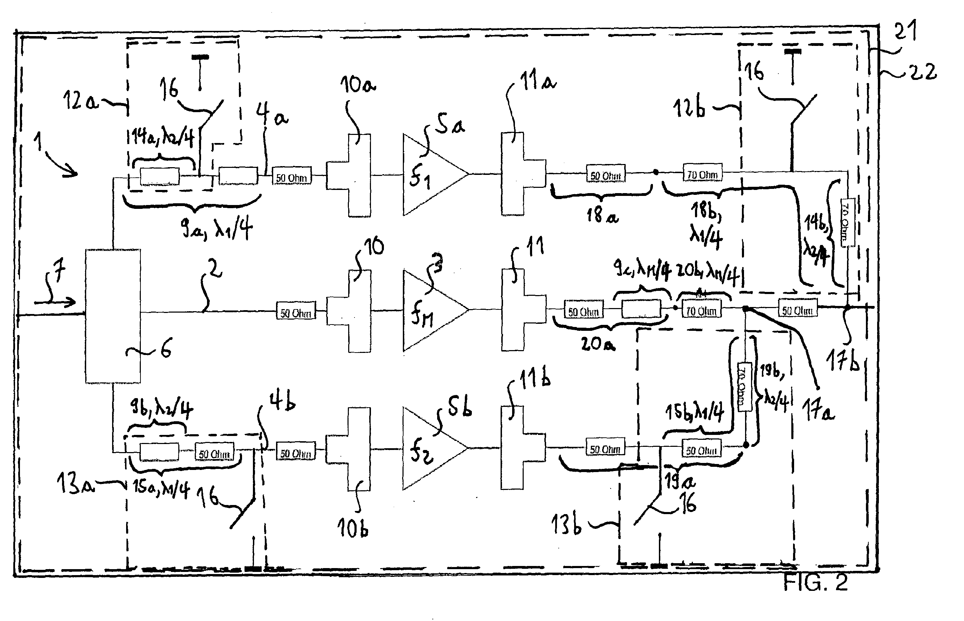

In the following, a detailed description of the proposed multi-band Doherty configuration will be given with respect to **Fig. 2****.** The multi-band Doherty amplifier **1** comprises a main amplification path **2** with a main amplifier **3**, and a first and second auxiliary amplification path **4a, 4b** with respective peak amplifiers **5a, 5b.** In the main amplification path 2, an input matching network **10** and an output matching network **11** are provided for matching the main amplifier 3 to a wide frequency range e.g. from about 2.3 to 2.7 GHz about a center frequency **f_{M}** of e.g. approx. 2.5 GHz. The first / second peak amplifier 5a, 5b of the first / second auxiliary amplification path 4a, 4b are matched to frequency bands having e.g. a first / second center frequency **f₁** = 2.4 GHz / **f₂** = 2.6 GHz by respective input matching networks **10a, 10b** and output matching networks **11a, 11b**. The first and second center frequencies f₁, f₂, resp. frequency bands are chosen such that they match two frequency bands contained in an input signal **7** to the Doherty amplifier 1. The input signal 7 is distributed to the main amplification path 2 and to the two auxiliary amplification paths 4a, 4b with equal power by a passive splitter **6.** As the different wavelengths / frequencies f₁, f₂ require different path lengths of the auxiliary amplification paths 4a, 4b, these are combined with the main signal path at combining points **17a, 17b** at different locations along the main amplification path 2, the combining points 17a, 17b being separated by a 50 Ohm line section. This is advantageous to guarantee a proper load modulation for both frequencies f₁, f₂, resp. auxiliary amplification paths 4a, 4b.

The main power amplifier 3 is typically implemented as a transistor having class A or AB, the peak amplifiers 5a, 5b as transistors having class C. If the power capability of the transistor of the main amplifier 3 is the same as that of the transistors of the peak amplifiers 5a, 5b, the Doherty amplifier 1 is in a symmetrical configuration. By choosing different power capabilities of the main amplifier 2 and the peak amplifiers 5a, 5b, an asymmetrical configuration can be achieved.

In the configuration shown in Fig. 2, the wideband matched main amplifier 3 is shared by the two peak amplifiers 5a, 5b which are narrowband matched to different center frequencies f₁, f₂. As will be described in greater detail below, the current waveband on which the whole Doherty amplifier 1 operates can be chosen in dependence of the currently used frequency band of the input signal 7 by selecting the peak amplifier 5a, 5b which is matched to that frequency band, at the same time deactivating the other peak amplifier 5b, 5a.

The deactivation is done by short circuiting the unused peak amplifier 5a, 5b through respective signal blocking units comprising an input blocking section **12a, 13a** at an input end to the respective peak amplifiers 5a, 5b and an output blocking section **12b, 13b** at an output end of the respective peak amplifiers 5a, 5b to the respective combining point 17a, 17b of the respective auxiliary amplification path 4a, 4b with the main amplification path 2. The input blocking section 12a and the output blocking section 12b of the first auxiliary amplification path 4a are adapted to block RF signals at the second center frequency f₂, whereas the input blocking section 13a and the output blocking section 13b of the second auxiliary amplification path 4b are adapted to block RF signals at the first center frequency f₁. For this purpose, the respective blocking sections 12a, 12b, 13a, 13b each comprise a quarter-wave line section **14a, 14b, 15a, 15b** having a length of λ₂ / 4 and λ₁ / 4, respectively, which is matched to the corresponding center frequency f₂, f₁. Furthermore, each of the blocking sections 12a, 12b, 13a, 13b comprises e.g. a PIN diode as a switching element **16,** being connected at one end to the respective quarter-wave line section 14a, 14b, 15a, 15b and to ground at the other end. The person skilled in the art will appreciate that alternatively, the switching element 16 may be implemented e.g. as a MEM-switch or as a RF-relay.

The quarter-wave line sections 14a, 15a of the input blocking sections 12a, 13a are arranged between the output of the splitter 6 and the respective switching elements 16 for blocking the input to the auxiliary amplification paths 4a, 4b, whereas the quarter-wave line sections 14b, 15b of the output blocking sections 12b, 13b are arranged between the respective combining points 17a, 17b and the switching elements 16 of the output blocking sections 12b, 13b for blocking the auxiliary amplification paths 4a, 4b at the respective combining points 17a, 17b.

When using the blocking sections 12a, 13a at the input end of the peak amplifiers 5a, 5b, a standard 3dB splitter 6 may be used for splitting the input signal 7 with equal power, the input signal 7 being switched to the currently used peak amplifier 5a, 5b by the respective switching elements 16. The blocking sections 12b, 13b at the output end of the peak amplifiers 5a, 5b generate an open signal path to the respective combination point 17a, 17b between the auxiliary amplification paths 4a, 4b and the main amplification path 2 so that the signal power doesn't get lost through the currently unused auxiliary amplification path. In RF theory, a quarter-wave section shorted to ground appears to be an open end for the RF signal related to the quarter-wave section. This fact is used to generate an open signal path to "switch off" the unused peak amplifier 5b, 5a.

In order to get a combined low-loss 50 Ohm output for the Doherty amplifier 1, the load modulation needs to be designed and matched via different impedance levels. For this purpose, the auxiliary amplification paths 4a, 4b from the output end of the peak amplifiers 5a, 5b to the respective combining points 17a, 17b are matched to the same characteristic impedance of 100 Ω.

For generating such a characteristic impedance, the auxiliary paths 4a, 4b from the output end of the peak amplifiers 5a, 5b to the respective combining point 17a, 17b comprise two line sections **18a, 18b** and **19a, 19b,** respectively. The first line sections 18a, 19a have a characteristic impedance of 50 Ohm, the second line sections 18b, 19b have a characteristic impedance of 70.7 Ohm. Furthermore, the second line sections 18b, 19b are quarter-wave line sections which are matched to the respective center frequency f₁, f₂ of the peak amplifiers 5a, 5b. In such a way, the characteristic impedance of the total of the two line sections 18a, 18b and 19a, 19b, respectively, is matched to 100 Ohm.

The main amplification path 2 from the main amplifier 3 to the first combining point 17a also comprises two line sections **20a, 20b** having a characteristic impedance of 50 Ohm and 70.7 Ohm, respectively, the second line section 20b being a quarter-wave line section matched to the center frequency of the main amplifier λ_{M} / 4, the characteristic impedance of the main amplification path 2 at the first combining point 17a being therefore also 100 Ohm. At the first combining point 17a, the characteristic impedances of the second auxiliary amplification path 4b and of the main amplification path 2 are combined (parallel circuit) to form a characteristic output impedance of 50 Ohm. In an analogous way, the first auxiliary amplification path 4a and the main amplification path 2 are combined at the second combining point 17b, resulting in an overall output impedance of 50 Ohm of the Doherty amplifier 1.

The person skilled in the art will readily recognize that in an analogous way as in Fig. 1, a first and second quarter-wave line section **9a, 9b** matched to the first / second center frequency f₁, f₂ are needed for the load balancing at the input end of the peak amplifiers 5a, 5b, i.e. before the input matching networks 10a, 10b (matched to an input impedance of 50 Ohm) and that a further quarter-wave line section 9c matched to the center frequency f_{M} of the main amplifier 3 is required at the output end of the main amplifier 3, the quarter-wave sections 9a to 9c being generated by line sections of appropriate length, as shown in Fig. 2.

The Doherty amplifier 1 may be integrated in a power amplifier module 21 which comprises additional circuitry allowing an easy integration of the multi-band Doherty amplifier 1 into a base station 22 for mobile radio applications. The base station 22 may then use different frequency bands located in a wide frequency range, thus allowing the base station 22 to operate with Software Defined Radio or Cognitive Radio applications. Due to the different combining positions of the two peak amplifiers 5a, 5b to the main amplifier 3, a good quality of load modulation for each frequency band is achieved, which is mandatory for high Doherty performance. In contrast thereto, due to the fact that a broadband delay line reduces the bandwidth of the load modulation and the other way round, the conventional Doherty approach is clearly bandwidth limited.

The person skilled in the art will appreciate that the concept described in Fig. 2 for the amplification of two frequency bands may be easily generalized for amplifying more than two wavelength bands by using more than two peak amplifiers. In this case, the blocking units must be adapted to block more than one frequency, which may be achieved by a connection of blocking sections in the respective auxiliary amplification paths, the blocking sections being matched to different center frequencies.

The above description of the preferred embodiments has been given by way of example. From the disclosure given, those skilled in the art will not only understand the present invention and its attendant advantages, but will also find apparent various changes and modifications to the structures and methods disclosed. The applicant seeks, therefore, to cover all such changes and modifications as defined by the appended claims, and equivalents thereof.

## Claims

1. Multi-band Doherty amplifier (1) for amplifying an input signal (7) in at least two frequency bands with different center frequencies (f₁, f₂), comprising:
a main amplification path (2) with a main amplifier (3), and
at least two auxiliary amplification paths (4a, 4b) with respective peak amplifiers (5a, 5b),
wherein the main amplifier (3) is wideband matched and a first / second peak amplifier (5a, 5b) of a first / second auxiliary amplification path (4a, 5b) is matched to the first / second center frequency (f₁, f₂),

2. Doherty amplifier according to claim 1, wherein the first / second amplification path (4a, 4b) comprises a first / second signal blocking unit (12a, 12b; 13a, 13b) for blocking the first / second auxiliary amplification path (4a, 4b) for the second / first center frequency (f₂, f₁).

3. Doherty amplifier according to claim 1, wherein the first / second signal blocking unit (12a,12b; 13a, 13b) comprises at least one quarter-wave line section (14a, 14b; 15a, 15b) matched to the second / first center frequency (f₂, f₁).

4. Doherty amplifier according to claim 3, wherein the first / second signal blocking unit (12a, 12b; 13a, 13b) further comprises at least one switching element (16) which is connected to the quarter-wave line section (14a, 14b; 15a, 15b).

5. Doherty amplifier according to claim 4, wherein the switching element is a PIN diode (16) or a MEM-switch.

6. Doherty amplifier according to claim 1, wherein the first / second signal blocking unit (12a, 12b; 13a, 13b) comprises an input blocking section (12a,13a) for blocking the first / second auxiliary amplification path (4a, 4b) to an input end of the first / second peak amplifier (5a, 5b), and an output blocking section (12b, 13b) for blocking the first / second auxiliary amplification path (4a, 4b) from a first / second combining point (17a, 17b) of the first / second auxiliary amplification path (4a, 4b) with the main amplification path (2) to an output end of the first /second peak amplifier (5a, 5b).

7. Doherty amplifier according to claim 1, further comprising a splitter (6) for distributing the input signal (7) to the main amplification path (2) and to the at least two auxiliary amplification paths (4a, 4b).

8. Doherty amplifier according to claim 1, wherein the auxiliary amplification paths (4a, 4b) are combined with the main signal path (2) at combining points (17a, 17b) arranged at different locations along the main signal path (2).

9. Doherty amplifier according to claim 8, wherein the auxiliary amplification paths (4a, 4b) from the output end of the peak amplifiers (5a, 5b) to the respective combining points (17a, 17b) are matched to the same characteristic impedance, preferably to 100 Ω.

10. Doherty amplifier according to claim 8, wherein the first / second auxiliary path (4a, 4b) from the output end of the first / second peak amplifier (5a, 5b) to the respective combining point (17a, 17b) comprises two line sections (18a, 18b; 19a, 19b) with different characteristic impedance, one of the line sections (18b, 19b) being a quarter-wave line section which is matched to the first / second center frequency (f₁, f₂).

11. Doherty amplifier according to claim 1, further comprising input matching networks (10, 10a, 10b) and an output matching networks (11, 11 a, 11 b) for the main amplifier (3) and the peak amplifiers (5a, 5b).

12. Doherty amplifier according to claim 1, wherein the main amplifier (3) and the peak amplifiers (5a, 5b) have the same power class.

13. Doherty amplifier according to claim 1, wherein the power class of the main amplifier (3) is different from the power class of the peak amplifiers (5a, 5b).

14. Power amplifier module (21) comprising a Doherty amplifier (1) according to claim 1.

15. Base station (22) for mobile radio applications comprising at least one power amplifier module (21) according to claim 14.
